# FASCICULE DE BREVET EUROPEEN

(11) **EP 1 448 490 B1**
(45) Date de publication et mention de la délivrance du brevet: **22.08.2007**
(21) Numéro de dépôt: 02796880.9
(22) Date de dépôt: 27.11.2002
(51) Int. Cl.: C03C 17/23, C03C 17/245, C03C 17/34, H01L 31/0236

(54) **SUBSTRAT TRANSPARENT MUNI D'UNE ELECTRODE**
TRANSPARENTES SUBSTRAT BESCHICHTET MIT EINER ELEKTRODE
TRANSPARENT SUBSTRATE COMPRISING AN ELECTRODE

(30) Priorité: 28.11.2001 FR 0115353
(43) Date de publication de la demande: 25.08.2004
(73) Titulaire: SAINT-GOBAIN GLASS FRANCE, 92400 Courbevoie (FR)
(72) Inventeur: BLIESKE, Ulf, 41236 Mönchengladbach (DE); DURANDEAU, Anne, F-75009 Paris (FR)
(74) Mandataire: Colombier, Christian
(86) Numéro de dépôt international: PCT/FR2002/004059
(87) Numéro de publication internationale: WO 2003/064344

## Description

L'invention se rapporte à un substrat transparent, notamment en verre, qui est muni d'une électrode. Ce substrat conducteur est plus particulièrement destiné à faire partie de cellules solaires. Il s'agit notamment de l'utiliser comme « face avant de cellule solaire, c'est-à-dire celle qui va se trouver directement exposée aux rayonnements solaires à convertir en électricité.

L'invention s'intéresse notamment aux cellules solaires de type Si ou CiS. On en rappelle brièvement la structure :

On commercialise généralement ce type de produit sous forme de cellules solaires montées en série et disposées entre deux substrats rigides transparents du type verre. Les cellules sont maintenues entre les substrats par un matériau polymère (ou plusieurs). Selon un mode de réalisation de l'invention qui est décrit dans le brevet EP- 739 042, les cellules solaires peuvent être placées entre les deux substrats, puis l'espace creux entre les substrats est rempli avec un polymère coulé apte à durcir, tout particulièrement à base de polyuréthane issu de la réaction d'un pré-polymère d'isocyanate aliphatique et d'un polyéther polyol. Le durcissement du polymère peut se faire à chaud (30 à 50°C) et éventuellement en légère surpression, par exemple dans un autoclave. D'autres polymères peuvent être utilisés, comme de l'éthylène vinylacétate EVA, et d'autres montages sont possibles (par exemple avec un feuilletage entre les deux verres des cellules à l'aide d'une ou de plusieurs feuilles de polymère thermoplastique).

C'est l'ensemble des substrats, du polymère et des cellules solaires que l'on désigne et que l'on vend sous le nom de « module solaire ».

L'invention a donc aussi pour objet lesdits modules.

Quand on sait que les modules solaires ne sont pas vendus au mètre carré, mais à la puissance électrique délivrée (approximativement, on peut estimer qu'un mètre carré de cellule solaire peut fournir environ 130 Watt), chaque pourcent de rendement supplémentaire accroît la performance électrique, et donc le prix, d'un module solaire de dimensions données.

L'invention a alors pour but de rechercher des moyens pour améliorer le rendement de conversion photoélectrique de ces modules, moyens ayant plus spécifiquement trait aux verres « avant » munis d'électrodes mentionnés plus haut. Avantageusement, on recherchera les moyens simples à mettre en oeuvre à l'échelle industrielle, ne bouleversant pas les structures et configurations connues pour ce type de produit.

L'invention à tout d'abord pour objet un substrat verrier tel que défini en revendication 1, muni d'une électrode comprenant au moins une couche transparente conductrice à base d'oxyde(s) métallique(s), ladite couche présente une rugosité RMS d'au moins 3nm. Elle est de préférence d'au moins 5nm, et notamment d'au plus 30nm. Une gamme de rugosité préférée se situe aux environs de 5 à 15nm.

Ce type de couche conductrice est connue sous l'abréviation anglaise T.C.O pour «Transparent Conductive Oxide». Elle est largement utilisée dans le domaine des cellules solaires et de l'électronique.

La rugosité R.M.S signifie rugosité « Root Mean Square ». Il s'agit d'une mesure consistant à mesurer la valeur de l'écart quadratique moyen de la rugosité. Cette rugosité R.M.S, concrètement, quantifie donc en moyenne la hauteur des pics et creux de rugosité, par rapport à la hauteur moyenne. Ainsi, une rugosité R.M.S de 3nm signifie une amplitude de pic double.

Elle peut être mesurée de différentes manières : par exemple, par microscopie à force atomique, par un système mécanique à pointe (utilisant par exemple les instruments de mesure commercialisés par la société VEECO sous la dénomination DEKTAK), par interférométrie optique. La mesure se fait généralement sur un micromètre carré par microscopie à force atomique, et sur une surface plus importante, de l'ordre de 50 micromètres à 2 millimètres pour les systèmes mécaniques à pointe.

Des rugosités RMS d'au moins 3 ou 5nm correspondent à des valeurs relativement élevées. La couche conductrice selon l'invention a une nature chimique connue, elle est de type oxyde métallique dopé. Par contre, elle a la spécificité d'être hautement rugueuse. De préférence, cette rugosité est aléatoire, en ce sens qu'elle ne présente pas de motifs d'une géométrie précise. En outre, elle est dispersée, suivant la taille de la surface mesurée.

Alternativement ou cumulativement, la rugosité de cette couche conductrice peut être également choisie de façon à ce que la taille moyenne des motifs de cette rugosité soit d'au moins 50nm, mesure faite dans la dimension parallèle à la surface du substrat. Avantageusement, elle est choisie d'au moins 100nm, et de préférence d'au plus 500nm. On privilégie une taille moyenne de motifs comprise entre 200 et 400nm. Cette taille moyenne peut être évaluée, notamment, par microscopie à balayage électronique. Quand la rugosité de la couche se présente sous forme de pics (de forme irrégulière), ce qui est le cas des couches cristallisées présentant une croissance colonnaire, cette taille moyenne correspond donc à la taille (la plus grande dimension) de la base de ces pics.

Cette rugosité particulière (rugosité R.M.S et/ou taille de motifs) s'est avérée très efficace. Elle permet en fait, aux interfaces entre la couche et les matériaux qui l'encadrent, une diffusion accrue de la lumière incidente, qui « oblige » celle-ci à avoir une trajectoire beaucoup plus longue à travers la cellule solaire.

En allongeant ainsi le trajet optique, on multiplie les chances d'absorption de la lumière par les éléments actifs de la cellule, et en final on augmente le taux de conversion photoélectrique de la cellule solaire. On piège ainsi mieux la lumière.

La rugosité définie précédemment peut être obtenue de façon faisable à l'échelle industrielle, par plusieurs moyens alternatifs ou cumulatifs.

Tout d'abord, on peut déposer la couche, puis la graver, par exemple par gravure chimique ou par sablage. On peut aussi la déposer directement de façon rugueuse, ce qui est plus avantageux sur le plan industriel, car cela évite une étape de traitement supplémentaire, discontinu, au milieu d'une succession d'étapes de dépôt des différentes couches constitutives de la cellule solaire.

On peut, dans les deux cas de figure, déposer la couche par différentes techniques. On peut la déposer, par exemple par une technique de pyrolyse, notamment en phase gazeuse (technique souvent désignée par l'abréviation anglaise de C.V.D, pour « Chemical Vapor Deposition »). Cette technique est intéressante pour l'invention car des réglages appropriés des paramètres de dépôt permettent d'obtenir une certaine rugosité.

On peut aussi déposer la couche par une technique de dépôt sous vide, notamment par pulvérisation cathodique assistée par champ magnétique. La pulvérisation peut être réactive (en partant de cibles métalliques ou sous-oxydées, en atmosphère oxydante) ou non réactive (en partant de cibles céramique, en atmosphère inerte).

Là encore, des modifications dans les paramètres de dépôts peuvent permettre d'obtenir une certaine porosité et/ou rugosité. On peut ainsi ajuster de façon appropriée la pression régnant dans la chambre de dépôt : une pression relativement élevée permet généralement d'obtenir des couches assez poreuses et rugueuses en surface. Une possibilité consiste à moduler ce paramètre en cours de dépôt, pour que la couche soit éventuellement relativement dense sur une certaine épaisseur, puis davantage poreuse/rugueuse en surface.

Selon l'invention, et on y reviendra en détails ultérieurement, on dépose la couche conductrice sur une surface elle-même rugueuse, notamment sur un verre qui présente lui-même une certaine, rugosité, ce qui peut provoquer ou amplifier sa rugosité.

La couche conductrice présente de préférence une épaisseur d'au maximum 1000 ou 700 ou 650nm. Son épaisseur est notamment d'au moins 400 nm, et par exemple comprise entre 400 et 800nm.

La couche conductrice peut être avantageusement choisie dans les matériaux suivants : oxyde d'étain dopé, notamment en fluor ou à l'antimoine (les précurseurs utilisables en cas de dépôt par CVD peuvent être des organo-métalliques ou halogénures d'étain associés avec un précurseur de fluor du type acide fluorhydrique ou acide trifluoracétique), l'oxyde de zinc dopé, notamment à l'aluminium (les précurseurs utilisables, en cas de dépôt par CVD, peuvent être des organo-métalliques ou halogénures de zinc et d'aluminium), ou encore l'oxyde d'indium dopé, notamment à l'étain (les précurseurs utilisables en cas de dépôt par CVD peuvent être des organo-métalliques ou halogénures d'étain et d'indium).

Selon une variante, on peut , qui peut être utilisée en tant que barrière aux espèces susceptibles de diffuser du verre, notamment les alcalins, tout particulièrement en cas de traitement thermique simultané ou postérieur au dépôt de la couche conductrice. Son rôle peut également être optique : en diminuant le niveau de réflexion lumineuse du substrat, elle permet d'augmenter la transmission lumineuse à travers la couche.

Il peut s'agir d'une couche à base d'oxyde, d'oxycarbure, d'oxynitrure ou de nitrure de silicium. On peut la déposer par le même type de technique que la couche conductrice, par exemple par pyrolyse (CVD) ou par pulvérisation cathodique, de façon connue.

On peut aussi la déposer de façon à ce qu'elle présente également une certaine rugosité.

Avantageusement, la couche conductrice présente résistance par carré d'au plus 30 ohms/carré, notamment d'au plus 20 ohms/carré, de préférence d'au plus 10 ou 15 ohms/carré. Elle est généralement comprise entre 5 et 12 ohms/carré.

Comme évoqué plus haut, selon l'invention la face A du substrat verrier sur laquelle est disposée directement ou indirectement (par l'intermédiaire d'autre(s) couche(s) comme les couches barrières pré-mentionnées) la couche conductrice présente elle-même une rugosité particulière.

La rugosité R.M.S de cette face A peut aller de 100 nm à 5000 nm et est avantageusement de 100 à 2000 nm et d'une manière préférable d'au moins 500 ou 1000 nm, de manière à obtenir une surface appelée Lambertienne dans la littérature. Cette rugosité R.M.S a la même signification et peut être mesurée de la même manière que celle de la couche conductrice décrite plus haut. Alternativement ou cumulativement, la rugosité de cette face A est telle que la taille moyenne des motif, mesurée selon une dimension parallèle à la surface du substrat, soit d'au moins 5 micromètres. Avantageusement, elle est comprise entre 5 et 100 micromètres, notamment entre 10 et 50 micromètres.

Cette rugosité est non uniforme, elle est aléatoire. Il n'y a pas de motifs réguliers à la surface du verre, mais des tailles variables d'excroissance et/ou de creux à la surface du verre, réparti(e)s au hasard sur toute ladite surface. Avantageusement, cette rugosité va permettre une diffusion de la lumière transmise par le substrat importante, et majoritairement « vers l'avant », c'est-à-dire de façon à faire diffuser la lumière, mais majoritairement vers l'intérieur de la cellule solaire.

Le but est, là encore, de « piéger » au mieux les rayons solaires incidents, et cela de différentes manières.
On crée une interface diffuse entre le verre et le matériau qui lui est contigu, et cette rugosité, au moins en partie, va se répercuter sur les couches qui vont être déposées successivement sur cette surface rugueuse : la couche tend à épouser la rugosité du substrat sur lequel elle est déposée.

Dans un mode de réalisation préféré de l'invention, la rugosité du substrat est bien supérieure à celle que peut avoir la couche elle-même : la couche, déposée sur une surface rugueuse, présente ainsi une rugosité de deux ordres.

En créant une surface rugueuse, on peut ainsi créer, en cascade, d'autre interfaces diffusantes successives, chacune des couches suivantes épousent plus au moins cette rugosité. Combiner un substrat verrier rugueux, dépoli avec une couche conductrice qui peut, elle aussi, avoir une rugosité intrinsèque ou provoquée, permet d'augmenter très significativement la part de diffusion dans la lumière transmise à l'intérieur de la cellule. On a alors un gain de rendement de conversion nettement amélioré, les rugosités des différents matériaux venant s'ajouter, se combiner de façon très intéressante.

Le "piégeage" de la lumière peut ainsi être amélioré, parce que la structure irrégulière en surface de la couche conductrice crée cette diffusion vers l'avant (en association avec la différence d'indice de réfraction existent entre la couche conductrice et la couche suivante à base de silicium), et/ou parce que la surface irrégulière éventuelle du verre crée également une diffusion vers l'avant (en association avec la différence d'indice de réfraction existant également entre le verre et la couche conductrice).

La rugosité de la face A du substrat verrier peut être obtenue par différents types de gravure, par exemple par sablage ou par gravure chimique. Dans ce dernier cas, il peut par exemple s'agir d'une opération de dépolissage à l'aide d'une solution comprenant de la soude et de l'acide fluorhydrique, ou de l'acide fluorhydrique seul. Généralement, on obtient un aspect de surface rappelant une succession de "cratères" jointifs ou non, avec ce type de dépolissage à l'acide. Ce dépolissage peut être faite en plusieurs étapes, avec des mises en contact successives de la face à traiter par des solutions différentes. Pour un dépolissage peu accentué, une solution d'acide fluorhydrique seule peut être utilisée. La concentration des éléments actifs de la solution et/ou le temps d'immersion du et/ou le nombre d'étapes lors de la gravure permettent de régler la taille et la profondeur des "trous" crées à la surface du verre. Avantageusement, le substrat verrier "rugueux" au moins sur cette face présente une transmission lumineuse globale d'au moins 70 ou 75%, notamment d'environ 80% selon l'Illuminant D65. La part de transmission diffuse peut être d'au moins 40 à 45%, notamment d'environ 50%.

Avantageusement encore, la couche conductrice est majoritairement cristallisée, avec notamment une taille de cristallites moyenne comprise entre 5 et 200nm , notamment entre 50 et 150nm.

Selon une variante, cumulative ou alternative avec la précédente, on peut choisir la face B du substrat verrier (celle qui est opposée à la face A précitée) de façon à ce qu'elle présente une certaine rugosité également. Cette rugosité peut être aléatoire, non uniforme, similaire à la rugosité de la face A décrite plus haut. Mais on peut aussi la choisir régulière, elle peut présenter des motifs du type réguliers : on est alors en présence d'une surface dite texturée. On comprend par texturation une pluralité de motifs géométriques en relief, concaves ou convexes par rapport au plan général de la face texturée du substrat.

Un type de texturation intéressante peut être défini de la façon suivante : le substrat est texturé sur au moins une de ses faces par une pluralité de motifs géométriques en relief par rapport au plan général de ladite face, la face texturée étant placée du côté de la réception de la lumière, la surface desdits motifs comprenant chacun au moins deux points tels qu'il existe deux plans sécants entre eux contenant chacun l'un desdits deux points et réunissant les deux conditions suivantes :
- ces plans sont tous des perpendiculaires au plan général de la face texturée de la plaque, et
- ces plans contiennent chacun l'une des deux droites perpendiculaires à ladite surface et passant par l'un desdits deux points.

Avantageusement, les points sont chacun sur une surface plane différente, et, les motifs sont des pyramides ayant un demi-angle au sommet.

La base des pyramides peut être carrée. Les motifs peuvent aussi être des cônes ayant un demi-angle au sommet par exemple inférieur à 70° ou à 60°, notamment compris entre 25 et 50°.

Avantageusement, le plus petit cercle pouvant contenir la base des motifs s'inscrit dans un cercle de diamètre compris entre 0.001 mm à 5mm.

Le point du motif le plus éloigné du plan général de la face texturée du substrat est avantageusement distant dudit plan d'une distance allant de 0,25 D à D, D représentant le diamètre du plus petit cercle contenu dans le plan général de la face texturée du substrat et pouvant contenir la base dudit motif.

La face texturée peut comprendre des motifs jointifs.

Selon un mode de réalisation, la face texturée comprend donc des motifs jointifs se terminant en pointe.

Avantageusement, le substrat verrier peut être de type extra-clair, c'est-à-dire très pauvre en oxydes colorants comme les oxydes de fer. Un exemple est le verre commercialisé sous le nom de DIAMANT par la société Saint-Gobain Glass. L'intérêt d'un tel verre est qu'il présente une très haute transmission lumineuse, ce qui va dans le sens d'une transmission aussi importante que possible des rayons solaires au sein de la cellule solaire.

L'invention a également pour objet l'utilisation du substrat décrit plus haut dans une cellule solaire, ainsi que la cellule solaire elle-même, et le module solaire dont elle peut faire partie.

L'invention sera détaillée ci-dessous à l'aide d'exemples non limitatifs et des figures suivantes :
- **figures 1a, 1b, 1c et 1d:** clichés obtenus par MEB (microscopie électronique à balayage) d'échantillons selon l'invention.
- **figures 2a et 2b** : schémas simplifiés d'une partie de cellule solaire selon l'invention, en coupe, selon deux variantes.

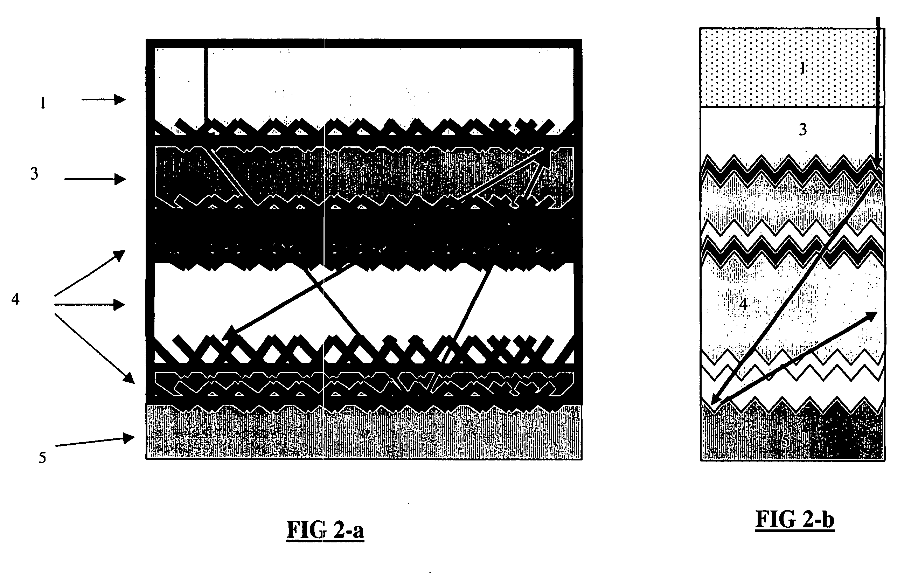

Les figures 2a et 2b montrent très schématiquement, et sans respect des échelles pour en faciliter la lecture, en coupe, une cellule solaire où la verre "avant" est rugueux (figure 2a) ou lisse (figure 2b) sur sa face interne. On appelle « face interne » la face où se trouvent, les unes sur les autres, toutes les couches de la cellule.

Dans les deux cas, on a successivement :
- un verre 1, en verre clair, 1-3mm d'épaisseur.
- une couche conductrice 3, à base d'oxyde d'étain dopé au fluor, obtenue par pyrolyse à partir des précurseurs (le dépôt de la couche a été effectué, de façon connue, par CVD en reprise, sur un verre chauffé vers 600°C
- un revêtement 4 à base silicium et de germanium, qui est une superposition du couches : p.a Si / i.a.Si / n.a Si /p.a SiGe / i.aSiGe / n.a SiGe
- une couche d'argent 5

### Exemple 1

Le verre 1 est un verre standard silico-sodo-calcique, commercialisé par Saint- Gobain Glass France sous l'appellation Planilux, sans aucun traitement particulier. La couche 3 en SnO₂:F a une épaisseur de 500nm. Elle présente une rugosité R.M.S d'environ 5 +/- 2nm.

### Exemple 2

Par rapport à l'exemple 1, le verre 1 est un verre qui a été dépoli, rendu diffusant par gravure chimique sur sa face B. La gravure a été faite de la façon suivante : on attaque la face en question par une solution aqueuse de NaOH/HF (ou HF seul) à pH 2 pendant 1 heure à 1 heure 30. On obtient un dépoli sous forme de sortes de cratères plutôt jointifs, créant des arêtes à la surface du verre. On mesure une rugosité R.M.S de l'ordre de 1,8 micromètre, et une taille de motifs de l'ordre de 50 micromètres.

### Exemple 3

Il est identique à l'exemple 2, mais cette fois c'est la face A du verre qui a été dépolie /rendue diffusante (comme la face B de l'exemple précédent). Dans ce cas de figure, on a donc la couche Sn02 : F qui est déposée sur le verre rugueux et qui "suit", au moins en partie, cette rugosité, outre sa rugosité propre qui peut être modulée, notamment par modification de ses paramètres de dépôt.

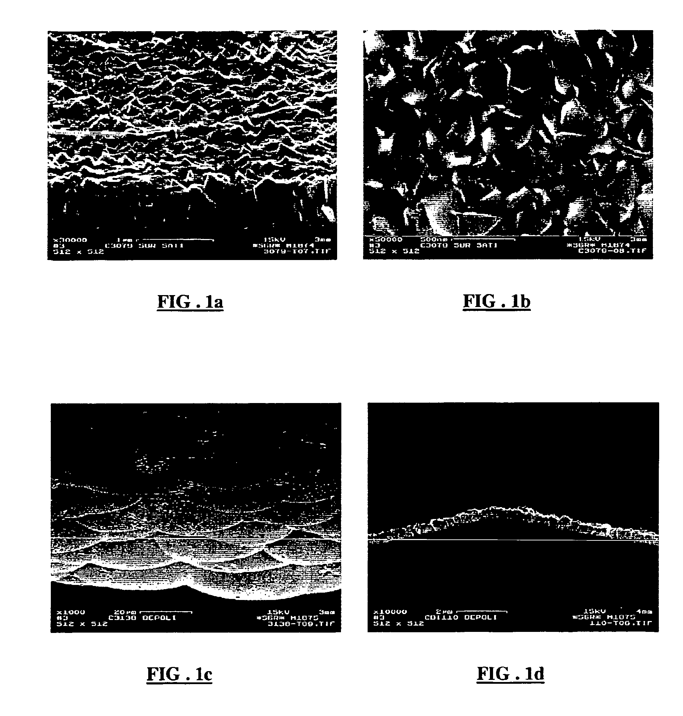

les figures 1a et 1b représentent la couche SnO₂:F vue selon son épaisseur (1a), et vue de dessus (1b), quand elle est déposée sur substrat lisse, conformément aux exemples 1 et 2 : on voit une couche bien cristallisée, avec une croissance essentiellement colonnaire, et une surface rugueuse, avec une taille de motif (mesurée selon un plan parallèle au verre porteur de la couche) qui est approximativement d'environ 200 à 300nm en moyenne.

La figure 1c et la figure 1d montrent la face rugueuse du verre recouverte de la couche en SnO₂:F selon l'exemple 3, vue de dessus (1c) et dans son épaisseur (1d): on voit le profil de cratère de la rugosité du verre, selon des motifs en creux, jointifs, qui est "suivi" par la couche, qui présente elle-même une rugosité, mais à une échelle bien moindre : on a donc une rugosité de la couche qui est de deux ordres.

Le tableau 1 ci-dessous regroupe par chacun des trois exemples, les données suivantes : (après montage, de façon connue et identique pour les trois exemples de la cellule).
- Jsc : la valeur en mA/Cm² de densité de courant générée par le module solaire, à zéro volt (c'est la densité de courant correspondant à un court circuit).
- FF (%): c'est l'abréviation anglaise pour "Fill Factor", qui est défini comme la puissance maximale de la cellule divisée par la valeur de Jsc et de Voc, qui est l'abréviation anglaise pour "open circuit voltage", c'est-à-dire la tension en circuit ouvert.
- η (%) : C'est l'efficacité solaire de la cellule, définie comme la puissance maximale de la cellule divisée par la puissance maximale lumineuse de la cellule à 1000W/m², à 25°C et selon un spectre AM 1,5.

**Tableau 1**

| | **J** | **FF** | **η** |
|---|---|---|---|
| Exemple 1 comparatif | 12.8 | 73.2 | 7.6 |
| Exemple 2 selon l'invention | 13.7 | 73.9 | 8.1 1 |
| Exemple 3 selon l'invention | 14.0 | 73.3 | 8.4 |

On voit qu'utiliser un verre dont l'une au moins des faces est rugueuse conduit à un gain de rendement non négligeable. Les meilleurs résultats sont obtenus quand c'est sur cette face rugueuse que la couche conductrice est déposée : sans en avoir entièrement expliqué les raisons, il apparaît en effet qu'entre la rugosité du verre et la rugosité intrinsèque de la couche, s'opère une synergie très favorable. On diffuse ainsi un maximum de lumière transmise par le verre 1, permettant à la lumière de traverser plusieurs fois, selon les angles d'incidence variables, les matériaux à base de silicium où s'effectue la conversion photoélectrique.

Il va de soi que l'invention s'applique de la même manière aux cellules solaires utilisant d'autres semi-conducteurs que ceux à base de silicium, comme CiS, CdTe, Ga As ou Gal n P, Ge, GaSb, InP, Gax Iny As, ou CuInSe₂.

L'invention peut aussi utiliser en tant que verre 1 du verre extra-clair, pour augmenter encore le pourcentage de lumière transmise par le verre.

L'invention concerne donc des électrodes où le verre 1 n'est pas rugueux, et où c'est la couche conductrice 3 qui est rugueuse, et réciproquement. La réalisation préférée de l'invention consiste à combiner leurs rugosités, comme l'illustre les figures 1c et 1d.

Quand, comme à l'exemple 3, on a superposition de deux rugosités, il peut devenir alors difficile de faire la part, à la surface de la couche conductrice, entre la rugosité conférée par le substrat et celle que la couche aurait si elle avait été déposée dans les mêmes conditions mais sur verre lisse, sur la performance globale de la cellule solaire : on a vraiment une combinaison d'effets. Les couches conductrices en ZnO dopé, notamment à l'aluminium sont des alternatives très intéressantes aux couches en oxyde d'étain dopé fluor utilisées dans les exemples.

La présente ne se limite pas aux exemples de réalisation précédemment décrits mais englobe également les variantes suivantes :
- on dispose entre le substrat verrier 1 et la couche conductrice 3 au moins une couche 2 à fonction de barrière aux espèces susceptibles de diffuser du verre, notamment les alcalins et/ou à fonction optique.
- la face A du substrat verrier 1 sur laquelle est disposée directement ou non la couche conductrice 3 présente elle-même une rugosité R.M.S d'au moins 100 nm., à savoir comprise entre 1000 et 5000nm, notamment comprise entre 1500 et 2000nm.

Par ailleurs, ce substrat verrier 1 muni d'une électrode comprenant au moins une couche transparente conductrice 3 à base d'oxyde(s) métallique(s) se caractérise en ce que la face A du substrat verrier 1 sur laquelle est disposée directement ou non la couche conductrice 3 présente une rugosité R.M.S d'au moins 1000nm, notamment comprise entre 1000 et 5000nm, et/ou une rugosité telle que la taille moyenne des motifs est d'au moins 5µm, notamment comprise entre 5 et 100µm.

On note également que la rugosité de la face B est une texturation régulière, avec notamment des motifs ayant la forme de cône ou de pyramide à base triangulaire ou carré, lesdits motifs étant concaves ou convexes.

## Revendications

1. Substrat verrier (1) muni d'une électrode comprenant au moins une couche transparente conductrice (3) à base d'oxyde(s) métallique(s) **caractérisé en ce que** ladite couche présente une rugosité RMS d'au moins 3nm, notamment d'au moins 5nm et/ou une taille moyenne des motifs de cette rugosité d'au moins 50nm, ladite couche étant disposée directement ou non sur une face (A) dudit substrat, cette dite face (A) présentant elle-même une rugosité R.M.S d'au moins 100 nm, la rugosité de la face A du substrat verrier (1) étant non uniforme/aléatoire de manière à obtenir une surface Lambertienne.

2. Substrat selon la revendication 1 **caractérisé en ce que** la rugosité R.M.S de la couche conductrice (3) est comprise entre 3nm et 30nm, notamment entre 5 et 15nm.

3. Substrat selon la revendication 1 ou la revendication 2 **caractérisé en ce que** les motifs de la rugosité de la couche conductrice ont une taille moyenne d'au moins 100nm, et notamment d'au plus 500nm.

4. Substrat selon l'une des revendications précédentes **caractérisé en ce que** les motifs de la rugosité de la couche conductrice ont une taille moyenne comprise entre 200 et 400nm.

5. Substrat selon l'une des revendications précédentes **caractérisé en ce que** la couche conductrice (3) est déposée par pyrolyse , notamment en phase gazeuse.

6. Substrat selon l'une des revendications 1 à 4 **caractérisé en ce que** la couche (3) est déposée par pulvérisation cathodique.

7. Substrat selon l'une des revendications précédentes **caractérisé en ce que** la couche conductrice (3) est choisie parmi l'oxyde d'étain dopé, notamment au fluor ou à l'antimoine, l'oxyde de zinc dopé, notamment à l'aluminium, et l'oxyde d'indium dopé, notamment à l'étain.

8. Substrat selon l'une des revendications précédentes **caractérisé en ce que** entre le substrat verrier (1) et la couche conductrice (3) est disposée au moins une couche (2) à fonction de barrière aux espèces susceptibles de diffuser du verre, notamment les alcalins et/ou à fonction optique.

9. Substrat selon la revendication 8 **caractérisé en ce que** la couche barrière (2) est à base d'oxyde, d'oxycarbure, d'oxynitrure ou de nitrure de silicium, notamment déposée par pyrolyse ou par pulvérisation cathodique.

10. Substrat selon l'une des revendications précédentes **caractérisé en ce que** la couche conductrice (3) a une résistance par carré d'au plus 30 ou 20 Ω/□, notamment d'au plus 15 Ω/□.

11. Substrat selon l'une des revendications précédentes **caractérisé en ce que** la couche conductrice (3) a une épaisseur d'au plus 1000nm, et de préférence d'au moins 400 nm.

12. Substrat selon la revendication 1 **caractérisé en ce que** la face A du substrat verrier présente elle-même une rugosité R.M.S comprise entre 100 et 5000nm, notamment comprise entre 1500 et 2000nm.

13. Substrat selon l'une des revendications précédentes **caractérisé en ce que** la face A du substrat verrier (1) sur laquelle est déposée directement ou non la couche conductrice (3) présente elle même une rugosité, avec une taille moyenne de motifs d'au moins 5µm, notamment d'au moins 10µm.

14. Substrat selon la revendication 13 **caractérisé en ce que** la face A du substrat verrier (1) présente une rugosité avec une taille moyenne de motifs comprise entre 5 et 100µm, notamment comprise entre 10 et 50µm.

15. Substrat verrier (1) muni d'une électrode comprenant au moins une couche transparente conductrice (3) à base d'oxyde(s) métallique(s) **caractérisé en ce que** la face A du substrat verrier (1) sur laquelle est disposée directement ou non la couche conductrice (3) présente une rugosité R.M.S d'au moins 100nm, notamment comprise entre 100 et 1000nm, et/ou une rugosité telle que la taille moyenne des motifs est d'au moins 5µm, notamment comprise entre 5 et 100 µm, la rugosité de la face A du substrat verrier (1) étant non uniforme/aléatoire de manière à obtenir une surface Lambertienne.

16. Substrat selon l'une des revendications 1 à 15 **caractérisé en ce que** la rugosité de la face A du substrat verrier (1) est obtenue par gravure chimique, ou par abrasion mécanique du type sablage.

17. Substrat selon l'une des revendications précédentes **caractérisé en ce que** la face B du substrat verrier (1) qui est opposée à la face A sur laquelle est disposée directement ou non la couche conductrice (3) présente une rugosité, aléatoire ou non aléatoire.

18. Substrat selon la revendication 17 et la revendication 1 ou la revendication 15 **caractérisé en ce que** la rugosité de la face B du substrat verrier (1) est aléatoire, similaire à celle de la face A de celui-ci.

19. Substrat selon la revendication 17 **caractérisé en ce que** la rugosité de la face B est une texturation régulière, avec notamment des motifs ayant la forme de cône ou de pyramide à base triangulaire ou carré, lesdits motifs étant concaves ou convexes.

20. **Substrat** selon l'une des revendications 1 à 15 **caractérisé en ce que** la face A du substrat verrier (1) présente une rugosité provoquant une diffusion de la lumière transmise vers l'avant, le substrat présentant notamment une transmission lumineuse globale d'au moins 70 à 75%, dont une transmission lumineuse diffuse d'au moins 40 à 45%.

21. Substrat selon l'une des revendications précédentes **caractérisé en ce que** la couche conductrice(s) est majoritairement, notamment essentiellement, cristallisée.

22. Utilisation du substrat selon l'une des revendications précédentes dans une cellule solaire.

23. Cellule solaire **caractérisée en ce qu'elle** comprend le substrat selon l'une des revendications 1 à 21.

## Claims

1. A glass substrate (1) provided with an electrode comprising at least one metal oxide-based transparent conducting layer (3), **characterized in that** said layer has an RMS roughness of at least 3 nm, especially at least 5 nm and/or a mean feature size for this roughness of at least 50 nm, said layer being placed directly or otherwise on one face (A) of said substrate, this substrate (A) itself having an RMS roughness of at least 100 nm, the roughness of the face (A) of the glass substrate (1) being not uniform/random in order to obtain a a Lambertian surface.

2. The substrate as claimed in claim 1, **characterized in that** the RMS roughness of the conducting layer (3) is between 3 nm and 30 nm, especially between 5 and 15 nm.

3. The substrate as claimed in claim 1 or claim 2, **characterized in that** the roughness features of the conducting layer have a mean size of at least 100 nm, and especially at most 500 nm.

4. The substrate as claimed in one of the preceding claims, **characterized in that** the roughness features of the conducting layer have a mean size of between 200 and 400 nm.

5. The substrate as claimed in one of the preceding claims, **characterized in that** the conducting layer (3) is deposited by pyrolysis, especially chemical vapor deposition.

6. The substrate as claimed in one of claims 1 to 4, **characterized in that** the layer (3) is deposited by sputtering.

7. The substrate as claimed in one of the preceding claims, **characterized in that** the conducting layer (3) is chosen from tin oxide doped especially with fluorine or antimony, zinc oxide doped especially with aluminum, and indium oxide doped especially with tin.

8. The substrate as claimed in one of the preceding claims, **characterized in that**, between the glass substrate (1) and the conducting layer (3) is placed at least one layer (2) having a barrier function against species capable of diffusing from the glass, especially alkali metals, and/or having an optical function.

9. The substrate as claimed in claim 8, **characterized in that** the barrier layer (2) is silicon oxide, oxycarbide, oxynitride or nitride based, especially deposited by pyrolysis or by sputtering.

10. The substrate as claimed in one of the preceding claims, **characterized in that** the conducting layer (3) has a resistance per square of at most 30 or 20 Ω/□, especially at most 15 Ω/□.

11. The substrate as claimed in one of the preceding claims, **characterized in that** the conducting layer (3) has a thickness of at most 1 000 nm, and preferably of at least 400 nm.

12. The substrate as claimed in claim 1, **characterized in that** the face A of the glass substrate itself has an RMS roughness of between 100 and 5 000 nm, especially between 1 500 and 2 000 nm.

13. The substrate as claimed in one of the preceding claims, **characterized in that** the face A of the glass substrate (1), on which the conducting layer (3) is deposited directly or otherwise, itself has a roughness, with a mean feature size of at least 5µm, especially of at least 10 µm.

14. The substrate as claimed in claim 13, **characterized in that** the face A of the glass substrate (1) has a roughness with a mean feature size of between 5 and 100 µm, especially between 10 and 50 µm.

15. A glass substrate (1) provided with an electrode comprising at least one transparent conducting layer (3) based on one or more metal oxides, **characterized in that** the face A of the glass substrate (1) on which the conducting layer (3) is placed directly or otherwise, has an RMS roughness of at least 100 nm, especially between 100 and 1 000 nm, and/or a roughness such that the mean feature size is at least 5 µm, especially between 5 and 100 µm, the roughness of the face (A) of the glass substrate (1) being not uniform/ random in order to obtain a a Lambertian surface.

16. The substrate as claimed in one of claims 1 to 15, **characterized in that** the roughness of the face A of the glass substrate (1) is obtained by chemical etching, or mechanical abrasion of the sandblasting type.

17. The substrate as claimed in one of the preceding claims, **characterized in that** the opposite face B of the glass substrate (1) from the face A on which the conducting layer (3) is placed directly or otherwise, has a random or nonrandom roughness.

18. The substrate as claimed in claim 17 and claim 1 or claim 15, **characterized in that** the roughness of the face B of the glass substrate (1) is random, similar to that of the face A thereof.

19. The substrate as claimed in claim 17, **characterized in that** the roughness of the face B has a regular texture, especially with features having the shape of a cone or pyramid with a triangular or square base, said features being concave or convex.

20. The substrate as claimed in one of claims 1 to 15, **characterized in that** the face A of the glass substrate (1) has a roughness causing diffusion of forward-transmitted light, the substrate especially having a total light transmission of at least 70 to 75%, which includes diffuse light transmission of at least 40 to 45%.

21. The substrate as claimed in one of the preceding claims, **characterized in that** the conducting layer(s) is predominantly, especially mainly, crystalline.

22. Use of the substrate as claimed in one of the preceding claims in a solar cell.

23. A solar cell, **characterized in that** it comprises the substrate as claimed in one of claims 1 to 21.

## Patentansprüche

1. Substrat (1), das aus Glas besteht und mit einer Elektrode versehen ist, die mindestens eine leitfähige transparente Schicht (3) auf der Basis von (einem) Metalloxid(en) umfasst, **dadurch gekennzeichnet, dass** diese Schicht eine RMS-Rautiefe von mindestens 3 nm, insbesondere mindestens 5 nm, und/oder eine mittlere Größe der Muster dieser Rautiefe von mindestens 50 nm aufweist und gegebenenfalls indirekt auf einer Seite (A) des Substrats angeordnet ist, die ihrerseits eine R.M.S-Rautiefe von mindestens 100 nm besitzt, wobei die Rautiefe der Seite A des aus Glas bestehenden Substrates (1) derart ungleichmäßig/zufällig ist, dass eine Lambert-Oberfläche erhalten wird.

2. Substrat nach Anspruch 1, **dadurch gekennzeichnet, dass** die R.M.S-Rautiefe der leitfähigen Schicht (3) 3 bis 30 nm und insbesondere zwischen 5 und 15 nm beträgt.

3. Substrat nach Anspruch 1 oder 2, **dadurch gekennzeichnet, dass** die mittlere Größe der Muster der Rauigkeit der leitfähigen Schicht mindestens 100 nm und insbesondere höchstens 500 nm beträgt.

4. Substrat nach einem der vorhergehenden Ansprüche, **dadurch gekennzeichnet, dass** die mittlere Größe der Muster der Rauigkeit der leitfähigen Schicht 200 bis 400 nm beträgt.

5. Substrat nach einem der vorhergehenden Ansprüche, **dadurch gekennzeichnet, dass** die leitfähige Schicht (3) durch Pyrolyse, insbesondere Gasphasenabscheidung, aufgebracht worden ist.

6. Substrat nach einem der Ansprüche 1 bis 4, **dadurch gekennzeichnet, dass** die Schicht (3) durch Kathodenzerstäubung aufgebracht worden ist.

7. Substrat nach einem der vorhergehenden Ansprüche, **dadurch gekennzeichnet, dass** die leitfähige Schicht (3) aus insbesondere mit Fluor oder Antimon dotiertem Zinnoxid, insbesondere mit Aluminium dotiertem Zinkoxid und insbesondere mit Zinn dotiertem Indiumoxid ausgewählt ist.

8. Substrat nach einem der vorhergehenden Ansprüche, **dadurch gekennzeichnet, dass** zwischen dem aus Glas bestehenden Substrat (1) und der leitfähigen Schicht (3) mindestens eine Schicht (2) mit der Funktion einer Barriere gegen Spezies, die in der Lage sind, aus dem Glas zu diffundieren, insbesondere Alkaliionen, und/oder mit einer optischen Funktion aufgebracht ist.

9. Substrat nach Anspruch 8, **dadurch gekennzeichnet, dass** die Barriereschicht (2) auf der Basis von Siliciumoxid, Siliciumcarbidoxid, Siliciumnitridoxid oder Siliciumnitrid ist und insbesondere durch Pyrolyse oder Kathodenzerstäubung aufgebracht worden ist.

10. Substrat nach einem der vorhergehenden Ansprüche, **dadurch gekennzeichnet, dass** der Flächenwiderstand der leitfähigen Schicht (3) höchstens 30 oder 20 Ω/□ und insbesondere höchstens 15 Ω/□ beträgt.

11. Substrat nach einem der vorhergehenden Ansprüche, **dadurch gekennzeichnet, dass** die Dicke der leitfähigen Schicht (3) höchstens 1 000 nm und vorzugsweise mindestens 400 nm beträgt.

12. Substrat nach Anspruch 1, **dadurch gekennzeichnet, dass** die R.M.S-Rautiefe der Seite A des aus Glas bestehenden Substrates 100 bis 5 000 nm und insbesondere 1 500 bis 2 000 nm beträgt.

13. Substrat nach einem der vorhergehenden Ansprüche, **dadurch gekennzeichnet, dass** die Seite A des aus Glas bestehenden Substrates (1), auf welcher gegebenenfalls indirekt die leitfähige Schicht (3) aufgebracht worden ist, eine Rautiefe von insbesondere mindestens 10 µm bei einer mittleren Größe der Muster von mindestens 5 µm besitzt.

14. Substrat nach Anspruch 13, **dadurch gekennzeichnet, dass** die Seite A des aus Glas bestehenden Substrates (1) eine Rautiefe von insbesondere 10 bis 50 µm bei einer mittleren Größe der Muster von 5 bis 100 µm besitzt.

15. Substrat (1), das aus Glas besteht und mit einer Elektrode versehen ist, die mindestens eine leitfähige transparente Schicht (3) auf der Basis von (einem) Metalloxid(en) umfasst, **dadurch gekennzeichnet, dass** die Seite A des aus Glas bestehenden Substrates (1), auf welcher gegebenenfalls indirekt die leitfähige Schicht (3) aufgebracht worden ist, eine R.M.S-Rautiefe von mindestens 100 nm, insbesondere 100 bis 1 000 nm, und/oder eine derartige Rautiefe, dass die mittlere Größe der Muster mindestens 5 µm und insbesondere 5 bis 100 µm beträgt, aufweist, wobei die Rautiefe der Seite A des aus Glas bestehenden Substrats (1) derart ungleichmäßig/zufällig ist, dass eine Lambert-Oberfläche erhalten wird.

16. Substrat nach einem der Ansprüche 1 bis 15, **dadurch gekennzeichnet, dass** die Rautiefe der Seite A des aus Glas bestehenden Substrates (1) durch chemisches Ätzen oder mechanisches Abtragen vom Typ Sandstrahlen erhalten worden ist.

17. Substrat nach einem der vorhergehenden Ansprüche, **dadurch gekennzeichnet, dass** die Seite B des aus Glas bestehenden Substrates (1), die der Seite A gegenüberliegt, auf welcher gegebenenfalls indirekt die leitfähige Schicht (3) aufgebracht worden ist, eine gegebenenfalls zufällige Rautiefe aufweist.

18. Substrat nach Anspruch 17 und Anspruch 1 oder 15, **dadurch gekennzeichnet, dass** die Rautiefe der Seite B des aus Glas bestehenden Substrates (1) zufällig und ähnlich derjenigen seiner Seite A ist.

19. Substrat nach Anspruch 17, **dadurch gekennzeichnet, dass** die Rauigkeit der Seite B eine regelmäßige Texturierung mit insbesondere Mustern, die die Form eines Kegels oder einer Pyramide mit dreieckiger oder quadratischer Grundfläche haben, ist, wobei diese Muster konkav oder konvex sind.

20. Substrat nach einem der Ansprüche 1 bis 15, **dadurch gekennzeichnet, dass** die Seite A des aus Glas bestehenden Substrates (1) eine Rauigkeit aufweist, die eine Streuung des hindurchgelassenen Lichtes nach vorn verursacht, wobei das Substrat insbesondere einen globalen Lichttransmissionsgrad von mindestens 70 bis 75 %, davon einen Streulichttransmissionsgrad von mindestens 40 bis 45 %, besitzt.

21. Substrat nach einem der vorhergehenden Ansprüche, **dadurch gekennzeichnet, dass** die leitfähige(n) Schicht(en) überwiegend und insbesondere im Wesentlichen kristallisiert (sind).

22. Verwendung des Substrats nach einem der vorhergehenden Ansprüche in einer Solarzelle.

23. Solarzelle, **dadurch gekennzeichnet, dass** sie das Substrat nach einem der Ansprüche 1 bis 21 umfasst.
